# FASCICULE DE BREVET EUROPEEN

(11) **EP 2 736 313 B1**
(45) Date de publication et mention de la délivrance du brevet: **28.06.2017**
(21) Numéro de dépôt: 13188014.8
(22) Date de dépôt: 10.10.2013
(51) Int. Cl.: H05K 7/14, H02B 1/044

(54) **Variateur de vitesse et système incluant une architecture pour renforcer l'étanchéité du variateur de vitesse**
Drehzahlregler und System, das eine Architektur zur Verstärkung der Dichtigkeit des Drehzahlreglers umfasst
Variable speed drive and system including an architecture for reinforcing the ingress protection of the variable speed drive

(30) Priorité: 26.11.2012 FR 1261244
(43) Date de publication de la demande: 28.05.2014
(73) Titulaire: Schneider Toshiba Inverter Europe SAS, 27120 Pacy sur Eure (FR)
(72) Inventeur: Leon, Frédéric, 27810 Marcilly sur Eure (FR)
(74) Mandataire: Dufresne, Thierry

(56) Documents cités:
- EP-A1- 2 509 402
- EP-A2- 1 150 555
- DE-A1-102008 034 417
- FR-A1- 2 947 692

## Description

### Domaine technique de l'invention

La présente invention se rapporte à un variateur de vitesse et à un système incluant ledit variateur de vitesse et une architecture pour renforcer l'étanchéité du variateur de vitesse.

### Etat de la technique

Dans l'art antérieur, il existe différentes solutions permettant de créer une architecture pour renforcer l'étanchéité d'un variateur de vitesse. Il s'agit par exemple de réaliser une architecture venant se rapporter sur le variateur de vitesse. Comme la partie arrière du variateur de vitesse qui porte le dissipateur thermique ne doit pas être recouverte, celle-ci doit présenter intrinsèquement un certain niveau d'étanchéité. En revanche, il est nécessaire d'assurer l'étanchéité de la partie avant si celle-ci présente un niveau d'étanchéité plus limité, par exemple IP00 ou IP20.

Une solution est par exemple décrite dans le brevet FR2947692. Dans ce brevet, le variateur de vitesse est passé à travers une ouverture réalisée dans un châssis et un joint étanche est posé entre le variateur et les bords de ladite ouverture. Un capot étanche est ensuite rapporté sur la partie avant du variateur de vitesse. L'ouverture réalisée dans le châssis est choisie suffisamment étendue pour pouvoir passer le variateur de vitesse à travers l'ouverture en opérant un simple mouvement de translation. Cependant, cette solution oblige l'emploi d'un joint spécifique permettant de combler de manière parfaitement étanche l'espace entre le corps du variateur de vitesse et les bords de l'ouverture réalisée dans le châssis. La mise en place du joint n'est pas aisée et le joint doit présenter une forme spécifique pour pouvoir assurer l'étanchéité souhaitée.

Dans une autre configuration, un joint est par exemple disposé contre une collerette réalisée sur la partie avant du variateur de vitesse. Lorsque le variateur de vitesse est inséré en translation à travers l'ouverture réalisée dans le châssis, le joint est comprimé entre la collerette et la zone située en périphérie de l'ouverture. Cette solution permet d'éviter l'emploi d'un joint spécifique mais nécessite de dimensionner l'ouverture réalisée dans le châssis pour que son contour suive la collerette réalisée sur le variateur de vitesse. Or, la partie arrière du variateur de vitesse dispose de pattes de fixation situées à l'arrière du variateur, ces pattes de fixation comprenant par exemple des perçages permettant de fixer le variateur de vitesse sur un support. Pour accéder à ces pattes de fixation, la partie avant et la partie arrière du variateur de vitesse sont formées de manière à présenter des passages permettant d'accéder, de l'avant du variateur de vitesse, aux pattes de fixation situées à l'arrière. La présence de ces pattes de fixation ne permet plus d'insérer le variateur de vitesse à travers l'ouverture réalisée dans le châssis, l'ouverture n'étant pas assez étendue. Dans l'état de la technique, il a été proposé de réaliser des pattes de fixation amovibles, qui sont retirées lorsque le variateur de vitesse est installé dans le châssis. Cependant, cela complique la fabrication de la partie arrière du variateur de vitesse et cela ne permet pas de proposer une partie arrière monobloc, c'est-à-dire réalisée en une seule pièce.

Le but de l'invention est de proposer un variateur de vitesse pouvant s'insérer à travers l'ouverture réalisée sur le châssis, tout en présentant des pattes de fixation inamovibles et proéminentes dans le plan de fixation du variateur de vitesse par rapport à la projection de la collerette dans ce plan.

### Exposé de l'invention

Ce but est atteint par un variateur de vitesse destiné à commander une charge électrique, ledit variateur de vitesse étant agencé pour s'insérer suivant un axe principal à travers une ouverture réalisée dans un châssis et comprenant une partie avant apte à supporter une interface de commande et une partie arrière assemblée sur la partie avant, la partie avant formant une collerette par rapport à la partie arrière, ladite partie arrière comprenant un corps principal présentant une section transversale ayant une forme externe agencée pour épouser le pourtour interne de l'ouverture, et un socle de fixation prolongeant le corps principal vers l'arrière, ledit socle de fixation comprenant plusieurs pattes de fixation, permettant de fixer le variateur de vitesse sur un support, la partie avant et la partie arrière du variateur de vitesse étant formées de manière à présenter des passages pour accéder, de l'avant du variateur de vitesse, à chaque patte de fixation située à l'arrière, lesdits passages étant réalisés parallèlement à l'axe principal, le variateur de vitesse comportant un dégagement réalisé sur le corps principal de la partie arrière, présentant une profondeur suffisante pour permettre de passer le socle de fixation à travers ladite ouverture.

Selon une particularité, le dégagement se présente sous la forme d'une fente réalisée sur une face du variateur de vitesse.

L'invention concerne un système de commande comprenant un variateur de vitesse et une architecture pour renforcer l'étanchéité du variateur de vitesse, ladite architecture comprenant un châssis présentant une ouverture destinée à accueillir le variateur de vitesse, le variateur de vitesse étant conforme à celui défini ci-dessus.

Selon une particularité du système, le châssis présente une section transversale rectangulaire formant une plaque avant à travers laquelle est réalisée l'ouverture en vue de réaliser un cadre et deux plaques latérales, la section étant interrompue dans le sens longitudinal sur son côté arrière de manière à former deux plaques arrières non jointives situées chacune dans le prolongement d'une plaque latérale.

Selon une autre particularité, le variateur de vitesse est agencé dans le châssis de manière à ce que sa partie avant émerge du châssis par rapport à un plan formé par la plaque avant.

Selon une autre particularité, l'architecture comporte un capot destiné à recouvrir la partie avant du variateur de vitesse.

Selon une autre particularité, le capot est réalisé en deux parties.

Selon une autre particularité, l'architecture étanche comporte un joint d'étanchéité comprimé entre la collerette et une zone située en périphérie de l'ouverture du châssis.

L'invention concerne enfin un procédé de montage d'un variateur de vitesse, tel que défini ci-dessus, dans un châssis comprenant une ouverture, le procédé comportant les étapes suivantes :
- insertion du dégagement dans un bord de l'ouverture pour faire passer les pattes de fixation supérieures en inclinant le variateur de vitesse par rapport au châssis,
- rotation du variateur de vitesse vers l'intérieur de l'ouverture pour le ramener dans la direction de l'axe principal et faire passer les pattes de fixation inférieures,
- translation du variateur de vitesse dans un plan perpendiculaire à l'axe principal pour désengager le dégagement du bord de l'ouverture,
- translation du variateur de vitesse suivant l'axe principal de manière à l'enfoncer jusqu'à ce que la collerette vienne en appui contre une zone située en périphérie de l'ouverture réalisée à travers le châssis.

### Brève description des figures

D'autres caractéristiques et avantages vont apparaître dans la description détaillée qui suit faite en regard des dessins annexés qui représentent :
- la figure 1 représente le système complet de l'invention, incluant le variateur de vitesse et l'architecture permettant de renforcer son étanchéité,
- les figure 2A et 2B représentent un variateur de vitesse, respectivement en vue de face et en vue de dessous,
- la figure 3 représente, en perspective, le variateur de vitesse à installer dans le châssis,
- les figures 4A et 4B illustrent la première étape de mise en place du variateur de vitesse sur son châssis,
- les figures 5A et 5B illustrent la deuxième étape de mise en place du variateur de vitesse sur son châssis,
- les figures 6A et 6B illustrent la troisième étape de mise en place du variateur de vitesse sur son châssis,
- les figures 7A et 7B illustrent la quatrième étape de mise en place du variateur de vitesse sur son châssis.

### Description détaillée d'au moins un mode de réalisation

L'invention s'applique à un variateur de vitesse 1 présentant préférentiellement une architecture en deux parties assemblées entre elles, une partie, dite avant, destinée à loger les éléments de contrôle/commande et une partie, dite arrière, destinée à loger les composants de puissance.

Pour la suite de la description, nous définissons un axe principal (X) suivant la direction avant-arrière du variateur de vitesse.

Les termes "supérieur" et "inférieur" doivent être compris en prenant comme référence l'axe principal (X) lorsque celui-ci est à l'horizontal.

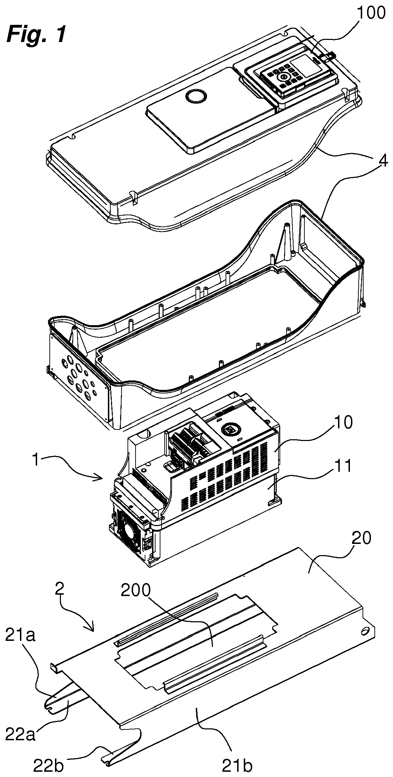

La partie avant 10 comporte un premier boîtier renfermant des cartes électroniques de contrôle destinées à la commande d'une charge électrique et est apte à supporter une interface de commande, c'est-à-dire un clavier et/ou un écran, se présentant par exemple sous la forme d'une télécommande 100 détachable, pouvant se déporter sur l'avant de l'architecture étanche (figure 1).

La partie arrière 11 comporte un deuxième boîtier assemblé sur le premier boîtier de la partie avant 10 et incluant les modules électroniques de puissance, le condensateur de bus et des moyens de ventilation et de dissipation thermique.

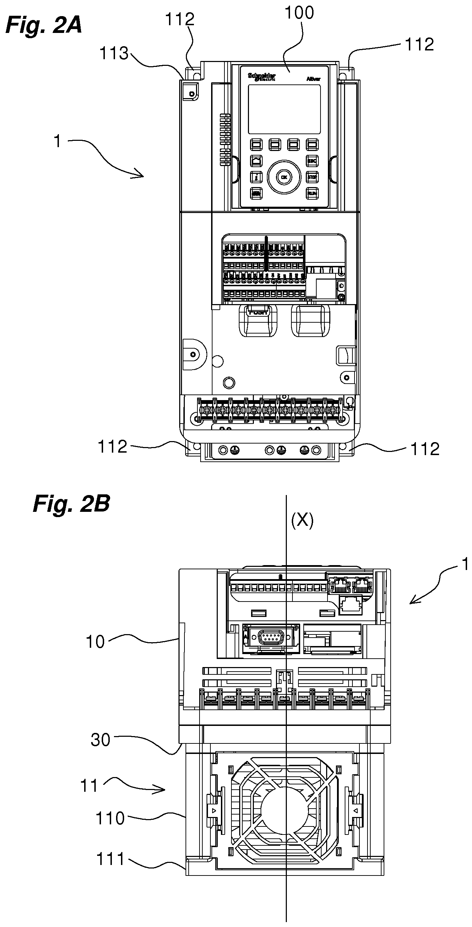

Le variateur de vitesse présente une forme générale parallélépipédique. Le variateur de vitesse comporte une collerette 30 (figure 2B) réalisée à la jonction entre la partie avant 10 et la partie arrière 11, ladite collerette 30 étant agencée pour servir de surface d'appui à un joint d'étanchéité, ladite surface d'appui étant réalisée dans un plan perpendiculaire à l'axe principal (X). La collerette 30 est réalisée sur tout le pourtour du variateur de vitesse.

La partie arrière 11 comporte un corps principal 110 situé le plus en avant et un socle de fixation 111 situé à l'arrière dudit corps principal. Ce socle de fixation 111 est employé pour fixer le variateur de vitesse 1 sur un support. Il comporte plusieurs pattes de fixations 112 (figure 2A), par exemple une à chaque coin, munies chacune d'un perçage. Les pattes de fixation 112 sont réalisées dans un plan, dit plan de fixation, perpendiculaire à l'axe principal (X), et sont proéminentes dans ce plan de fixation par rapport à la projection de la collerette réalisée dans ledit plan. Le variateur de vitesse 1 comporte en effet des passages 113 réalisées parallèlement à l'axe principal (X) permettant d'accéder, de l'avant du variateur de vitesse 1, aux pattes de fixation 112 situées à l'arrière du variateur de vitesse. Ces passages 113 sont réalisés sur toute la profondeur du variateur de vitesse.

L'architecture étanche est employée pour renforcer l'étanchéité de la partie avant 10 du variateur de vitesse. L'architecture de l'invention permet par exemple d'obtenir un variateur de vitesse ayant un niveau d'étanchéité IP55. Bien entendu, pour obtenir un niveau d'étanchéité IP55, il est nécessaire que la partie arrière 11 du variateur de vitesse soit intrinsèquement à ce niveau d'étanchéité IP55. La partie avant 10 du variateur qui est initialement à un niveau d'étanchéité faible (IP20 ou IP00) se trouve alors renforcée grâce à une architecture étanche pour arriver à un niveau d'étanchéité IP55.

L'architecture de l'invention est constituée principalement d'un châssis 2 présentant un design adapté, d'un joint d'étanchéité 3 permettant d'assurer l'étanchéité entre le variateur de vitesse 1 et le châssis 2, et plus précisément de la partie avant 10 du variateur de vitesse sur le châssis 2 et d'un capot 4 étanche destiné à recouvrir la partie avant 10 du variateur de vitesse 1 et par exemple réalisé en deux parties.

Selon l'invention, le châssis 2 est par exemple réalisé en matériau métallique et présente une section transversale rectangulaire interrompue sur l'un de ses côtés dans le sens longitudinal. De cette façon, le châssis comporte une plaque principale avant 20, deux plaques latérales 21 a, 21 b perpendiculaires à la plaque avant 20 et deux plaques arrières 22a, 22b non jointives situées dans un même plan, parallèle au plan de la plaque avant 20.

La plaque avant 20 présente une ouverture 200 de manière à former un cadre métallique. L'ouverture 200 est réalisée de manière à épouser la forme du corps principal 110 de la partie arrière, lors d'une translation axiale du variateur de vitesse à travers l'ouverture 200. Cette ouverture 200 épouse donc notamment les contours formant les passages 113 d'accès aux pattes de fixation 112. L'ouverture 200 n'est donc pas rectangulaire en ce qu'elle comporte à ses quatre coins une découpe venant épouser la forme du variateur de vitesse au niveau des passages 113 d'accès aux pattes de fixation 112.

Le variateur de vitesse 1 est destiné à être inséré, suivant une direction axiale, à travers l'ouverture 200 réalisée dans la plaque avant 20 du châssis 2. La partie avant 10 du variateur de vitesse 1 émerge du châssis par rapport au plan formé par la plaque avant 20 du châssis. Le variateur de vitesse 1 est positionné de manière à présenter des faces latérales, supérieur et inférieur, parallèles à l'axe de l'ouverture 200 et donc perpendiculaires au plan formé par les plaques avant et arrière du châssis 2.

Selon l'invention, l'ouverture 200 réalisée dans le châssis est dimensionnée pour que la zone située en périphérie de ladite ouverture 200 vienne en appui contre la surface d'appui formée par la collerette 30 réalisée sur le variateur de vitesse. Un joint d'étanchéité est ainsi positionné entre ladite collerette et la zone située en périphérie de l'ouverture réalisée dans le châssis. L'ouverture 200 du châssis est réalisée de manière à épouser la forme externe du corps principal 110 de la partie arrière 11 du variateur de vitesse.

Comme décrit précédemment, les pattes de fixation 112 sont en proéminence dans le plan de fixation par rapport aux projections du corps principal 110 de la partie arrière 11 et de la collerette 30 dans ce plan. L'engagement du variateur de vitesse 1 à travers l'ouverture 200 du châssis 2 jusqu'à la butée formée par la collerette 30 est permis grâce à un dégagement 40 réalisé sur le corps principal 110 de la partie arrière 11. Ce dégagement 40 est agencé pour permettre de faire passer le socle de fixation 111, et donc les pattes de fixation 112, à travers l'ouverture 200 du châssis 2. Le dégagement 40 se présente par exemple sous la forme d'une fente réalisée sur la surface supérieure ou inférieure de la partie arrière 11, juste en avant des pattes de fixation 112, dans un plan parallèle au plan de fixation. Elle est agencée pour recevoir un bord de l'ouverture 200.

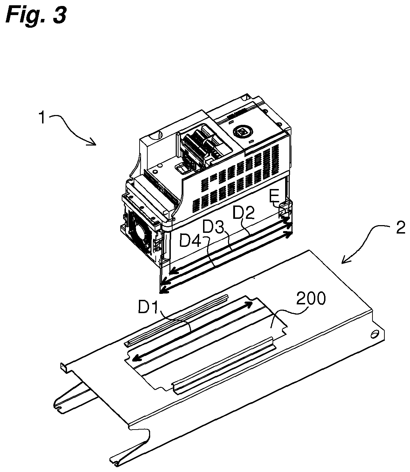

Sur la figure 3, on définit les différents paramètres suivants :
D1 correspond à la distance entre deux bords opposés parallèles de l'ouverture 200.
D2 correspond à la distance entre le bord supérieur et le bord inférieur parallèles de la collerette 30.
D3 représente la distance entre la face supérieure et la face inférieure du variateur de vitesse 1, au niveau du corps principal 110 de la partie arrière.
D4 représente la distance entre le bord supérieur et le bord inférieur parallèles du socle de fixation 111.
E représente la profondeur de la fente réalisée sur le variateur de vitesse 1.

Pour permettre de venir insérer le variateur de vitesse 1 à travers l'ouverture 200 du châssis 2, on a ainsi les contraintes suivantes à respecter :
- D2>D1 pour venir appliquer la collerette 30 contre la zone située en périphérie de l'ouverture 200.
- D3<D1 pour pouvoir engager le variateur de vitesse 1 à travers l'ouverture 200.
- D4>D1 ce qui empêche la translation du variateur de vitesse à travers l'ouverture.
- D4-E<D1 ce qui permet le passage du socle de fixation à travers l'ouverture.

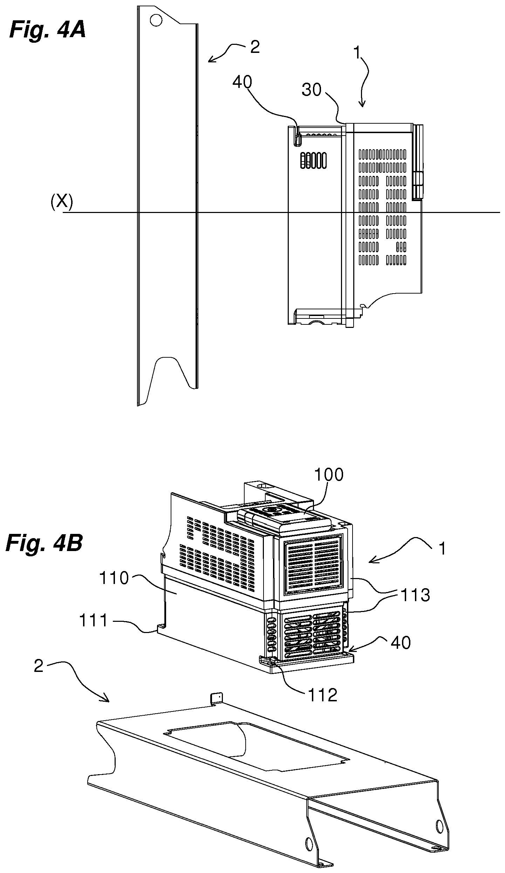

Les figures 4A à 7B permettent d'illustrer la mise en place du variateur de vitesse 1 sur le châssis 2.

Sur les figures 4A et 4B, le bord supérieur de l'ouverture 200 est engagé dans le dégagement 40 en inclinant légèrement le variateur de vitesse 1 par rapport au plan de fixation, permettant ainsi de passer les pattes de fixation supérieures.

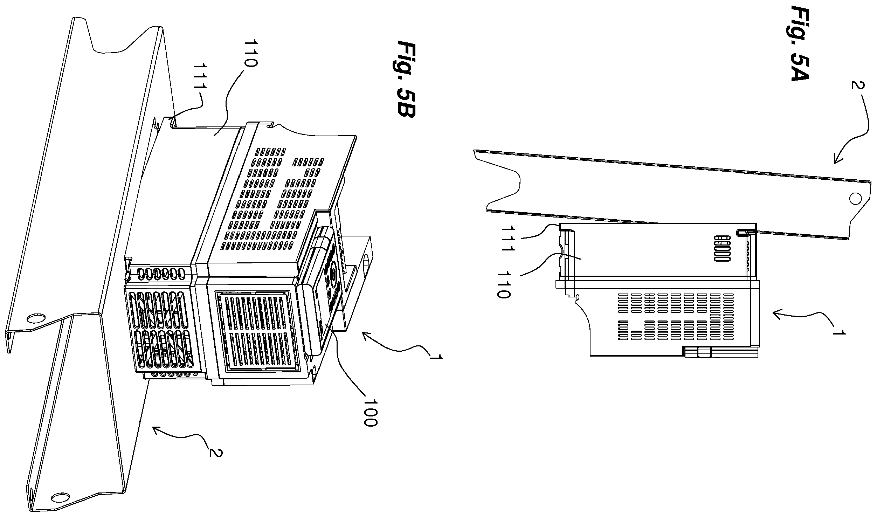

Sur les figures 5A et 5B, le variateur de vitesse est ramené dans le plan de fixation de manière à faire passer les pattes de fixation inférieures.

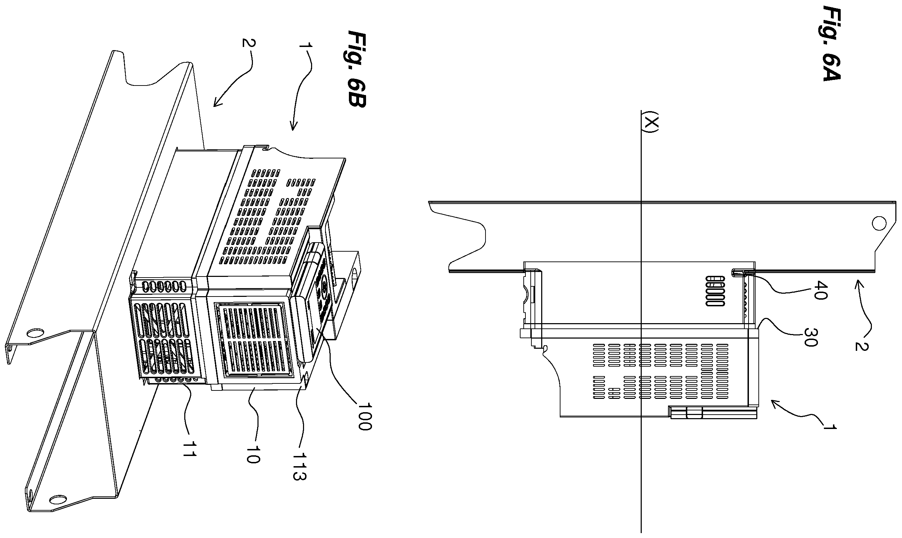

Sur les figures 6A et 6B, le variateur de vitesse est translaté vers le bas, permettant de désengager le bord supérieur de l'ouverture de la fente. Le bord inférieur de l'ouverture 200 vient alors en appui contre la face inférieure du corps principal 110 de la partie arrière 11.

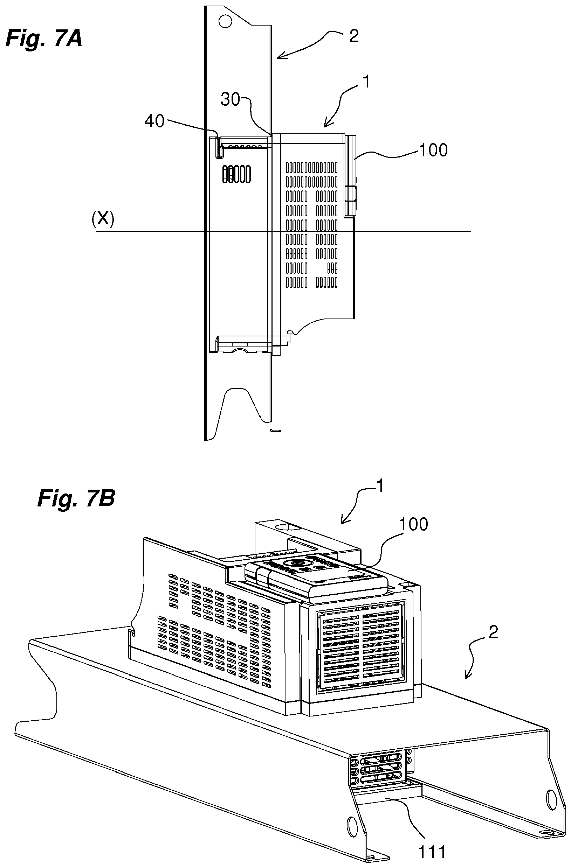

Sur les figures 7A et 7B, le variateur de vitesse 1 est poussé à travers le châssis 2 dans un mouvement de translation réalisé suivant l'axe principal, jusqu'à ce que la collerette 30 vienne en butée contre la zone située en périphérie de l'ouverture 200, comprimant ainsi le joint d'étanchéité.

L'invention permet ainsi de proposer une solution facile à installer, permettant d'obtenir une étanchéité satisfaisante, sans toucher à la structure du variateur de vitesse. Le variateur de vitesse présente notamment une configuration simple composée de deux parties principales assemblées entre elles, le boîtier de la partie arrière 110 étant réalisé en une seule pièce.

## Revendications

1. Variateur de vitesse (1) destiné à commander une charge électrique, ledit variateur de vitesse (1) étant agencé pour s'insérer suivant un axe principal (X), défini selon une direction avant-arrière du variateur de vitesse, à travers une ouverture (200) réalisée dans un châssis (2) et comprenant une partie avant (10) apte à supporter une interface de commande et une partie arrière (11) assemblée sur la partie avant, la partie avant (10) formant une collerette (30) par rapport à la partie arrière (11), ladite collerette (30) étant configurée pour venir s'appuyer sur la zone située en périphérie de l'ouverture (200) réalisée dans le châssis et comprimer un joint positionné entre la collerette (30) et la zone située en périphérie de l'ouverture, ladite partie arrière (11) comprenant un corps principal (110) présentant une section transversale ayant une forme externe agencée pour épouser le pourtour interne de l'ouverture (200), et un socle de fixation (111) prolongeant le corps principal (110) vers l'arrière, ledit socle de fixation (111) comprenant plusieurs pattes de fixation (112), permettant de fixer le variateur de vitesse (1) sur un support, la partie avant (10) et la partie arrière (11) du variateur de vitesse étant formées de manière à présenter des passages (113) pour accéder, de l'avant du variateur de vitesse, à chaque patte de fixation (112) située à l'arrière, lesdits passages (113) étant réalisés parallèlement à l'axe principal (X), le variateur de vitesse comportant un dégagement (40) réalisé sur le corps principal (110) de la partie arrière, présentant une profondeur suffisante pour permettre de passer le socle de fixation (111) à travers ladite ouverture (200).

2. Variateur de vitesse selon la revendication 1, **caractérisé en ce que** le dégagement (40) se présente sous la forme d'une fente réalisée sur une face du variateur de vitesse.

3. Système comprenant un variateur de vitesse selon l'une des revendications 1 et 2 et une architecture pour renforcer l'étanchéité du variateur de vitesse, ladite architecture comprenant un châssis (2) présentant une ouverture (200) destinée à accueillir le variateur de vitesse (1).

4. Système selon la revendication 3, **caractérisé en ce que** le châssis (2) présente une section transversale rectangulaire formant une plaque avant (20) à travers laquelle est réalisée l'ouverture (200) en vue de réaliser un cadre et deux plaques latérales, la section étant interrompue dans le sens longitudinal sur son côté arrière de manière à former deux plaques arrières (22a, 22b) non jointives situées chacune dans le prolongement d'une plaque latérale (21 a, 21 b).

5. Système selon la revendication 3 ou 4, **caractérisé en ce que** le variateur de vitesse (1) est agencé dans le châssis de manière à ce sa partie avant (10) émerge du châssis (2) par rapport à un plan formé par la plaque avant (20).

6. Système selon l'une des revendications 3 à 5, **caractérisée en ce que** l'architecture comporte un capot (4) destiné à recouvrir la partie avant (10) du variateur de vitesse.

7. Système selon la revendication 6, **caractérisé en ce que** le capot est réalisé en deux parties.

8. Système selon la revendication 7, **caractérisée en ce que** l'architecture étanche comporte un joint d'étanchéité comprimé entre la collerette (30) et une zone située en périphérie de l'ouverture (200) du châssis (2).

9. Procédé de montage d'un variateur de vitesse, selon l'une des revendications 1 ou 2, dans un châssis (2) comprenant une ouverture (200), **caractérisé en ce qu'**il comporte les étapes suivantes :
- insertion du dégagement (40) dans un bord de l'ouverture (200) pour faire passer les pattes de fixation (112) supérieures en inclinant le variateur de vitesse (1) par rapport au châssis (2),
- rotation du variateur de vitesse (1) vers l'intérieur de l'ouverture (200) pour le ramener dans la direction de l'axe principal (X) et faire passer les pattes de fixation inférieures,
- translation du variateur de vitesse (1) dans un plan perpendiculaire à l'axe principal (X) pour désengager le dégagement du bord de l'ouverture,
- translation du variateur de vitesse (1) suivant l'axe principal (X) de manière à l'enfoncer jusqu'à ce que la collerette (30) vienne en appui contre une zone située en périphérie de l'ouverture (200) réalisée à travers le châssis (2) et comprime un joint positionné entre la collerette (30) et la zone située en périphérie de l'ouverture (200).

## Patentansprüche

1. Umrichter (1), der dazu bestimmt ist, eine elektrische Last zu steuern, wobei der Umrichter (1) eingerichtet ist, gemäß einer Hauptachse (X), die entsprechend einer Richtung des Umrichters von vorne nach hinten definiert wird, durch eine in einem Gestell (2) hergestellte Öffnung (200) eingefügt zu werden, und einen vorderen Teil (10), der eine Steuerschnittstelle tragen kann, und einen hinteren Teil (11) enthält, der mit dem vorderen Teil zusammengebaut ist, wobei der vordere Teil (10) bezüglich des hinteren Teils (11) einen Kragen (30) bildet, wobei der Kragen (30) konfiguriert ist, sich auf die am Umfang der im Gestell hergestellten Öffnung (200) befindliche Zone aufzulegen und eine Dichtung zusammenzudrücken, die zwischen dem Kragen (30) und der am Umfang des Kragens befindlichen Zone positioniert ist, wobei der hintere Teil (11) einen Hauptkörper (110) mit einem Querschnitt, der eine Außenform hat, die eingerichtet ist, um sich dem inneren Umriss der Öffnung (200) anzupassen, und einen Befestigungssockel (111) aufweist, der den Hauptkörper (110) nach hinten verlängert, wobei der Befestigungssockel (111) mehrere Befestigungslaschen (112) enthält, die es ermöglichen, den Umrichter (1) an einem Träger zu befestigen, wobei der vordere Teil (10) und der hintere Teil (11) des Umrichters so ausgebildet sind, dass sie Durchlässe (113) aufweisen, um von der Vorderseite des Umrichters auf jede hinten befindliche Befestigungslasche (112) zuzugreifen, wobei die Durchlässe (113) parallel zur Hauptachse (X) hergestellt sind, wobei der Umrichter eine auf dem Hauptkörper (110) des hinteren Teils hergestellte Aussparung (40) aufweist, die eine ausreichende Tiefe aufweist, um es zu erlauben, den Befestigungssockel (111) durch die Öffnung (200) zu führen.

2. Umrichter nach Anspruch 1, **dadurch gekennzeichnet, dass** die Aussparung (40) in Form eines Schlitzes vorliegt, der auf einer Seite des Umrichters hergestellt ist.

3. System, das einen Umrichter nach einem der Ansprüche 1 und 2 und einen Aufbau enthält, um die Dichtheit des Umrichters zu verstärken, wobei der Aufbau ein Gestell (2) enthält, das eine Öffnung (200) aufweist, die dazu bestimmt ist, den Umrichter (1) aufzunehmen.

4. System nach Anspruch 3, **dadurch gekennzeichnet, dass** das Gestell (2) einen rechtwinkligen Querschnitt aufweist, der eine vordere Platte (20) bildet, durch die hindurch die Öffnung (200) hergestellt ist, um einen Rahmen und zwei seitliche Platten herzustellen, wobei der Querschnitt in Längsrichtung auf seiner Rückseite unterbrochen ist, um zwei nicht aneinandergrenzende hintere Platten (22a, 22b) zu bilden, die sich je in der Verlängerung einer seitlichen Platte (21 a, 21 b) befinden.

5. System nach Anspruch 3 oder 4, **dadurch gekennzeichnet, dass** der Umrichter (1) so im Gestell eingerichtet ist, dass sein vorderer Teil (10) bezüglich einer von der vorderen Platte (20) gebildeten Ebene aus dem Gestell (2) austritt.

6. System nach einem der Ansprüche 3 bis 5, **dadurch gekennzeichnet, dass** der Aufbau eine Haube (4) aufweist, die dazu bestimmt ist, den vorderen Teil (10) des Umrichters zu bedecken.

7. System nach Anspruch 6, **dadurch gekennzeichnet, dass** die Haube aus zwei Teilen hergestellt wird.

8. System nach Anspruch 7, **dadurch gekennzeichnet, dass** der dichte Aufbau eine Dichtung aufweist, die zwischen dem Kragen (30) und einer am Umfang der Öffnung (200) des Gestells (2) befindlichen Zone zusammengedrückt wird.

9. Verfahren zur Montage eines Umrichters nach einem der Ansprüche 1 oder 2 in ein eine Öffnung (200) enthaltendes Gestell (2), **dadurch gekennzeichnet, dass** es die folgenden Schritte aufweist:
- Einfügen der Aussparung (40) in einen Rand der Öffnung (200), um die oberen Befestigungslaschen (112) durchzulassen, indem der Umrichter (1) bezüglich des Gestells (2) geneigt wird,
- Drehen des Umrichters (1) zum Inneren der Öffnung (200), um ihn in die Richtung der Hauptachse (X) zurückzubringen und die inneren Befestigungslaschen durchzuführen,
- Translationsbewegung des Umrichters (1) in einer Ebene lotrecht zur Hauptachse (X), um die Aussparung vom Rand der Öffnung zu lösen,
- Translationsbewegung des Umrichters (1) gemäß der Hauptachse (X), um ihn einzudrücken, bis der Kragen (30) gegen eine am Umfang der durch das Gestell (2) hindurch hergestellten Öffnung (200) befindliche Zone in Auflage kommt und eine zwischen dem Kragen (30) und der am Umfang des Kragens (200) befindlichen Zone positionierte Dichtung zusammendrückt.

## Claims

1. Variable speed drive (1) intended to control an electrical load, said variable speed drive (1) being constructed to be inserted along a main axis (X) defined by a front-rear direction of the variable speed drive, through an opening (200) produced in a frame (2) and comprising a front part (10) suitable for supporting a control interface and a rear part (11) assembled on the front part, the front part (10) forming a flange (30) relative to the rear part (11), said flange (30) being arranged to bear against the area situated at the periphery of the opening (200) produced in the frame, thus compressing a gasket positioned between the flange (30) and the area situated at the periphery of the opening, said rear part (11) comprising a main body (110) having a cross section with an outer shape constructed to closely fit the inner perimeter of the opening (200), and a fixing plinth (111) extending the main body (110) towards the rear, said fixing plinth (111) comprising a plurality of fixing tabs (112), making it possible to fix the variable speed drive (1) on a support, the front part (10) and the rear part (11) of the variable speed drive being formed in such a way as to have passages (113) to access, from the front of the variable speed drive, each fixing tab (112) situated at the rear, said passages (113) being produced parallel to the main axis (X),
the variable speed drive comprising an undercut (40) produced on the main body (110) of the rear part, having a sufficient depth to allow the fixing plinth (111) to pass through said opening (200).

2. Variable speed drive according to Claim 1, **characterized in that** the undercut (40) takes the form of a slot produced on a face of the variable speed drive.

3. System comprising a variable speed drive according to one of Claims 1 and 2, and an architecture for reinforcing the ingress protection of the variable speed drive, said architecture comprising a frame (2) having an opening (200) intended to accommodate the variable speed drive (1).

4. System according to Claim 3, **characterized in that** the frame (2) has a rectangular cross section forming a front plate (20) through which the opening (200) is produced in order to produce a mounting and two side plates, the section being interrupted in the longitudinal direction on its rear side so as to form two non-contiguous rear plates (22a, 22b) each situated in the extension of a side plate (21a, 21b).

5. System according to Claim 3 or 4, **characterized in that** the variable speed drive (1) is constructed in the frame in such a way that its front part (10) emerges from the frame (2) relative to a plane formed by the front plate (20).

6. System according to one of Claims 3 to 5, **characterized in that** the architecture comprises a cover (4) intended to cover the front part (10) of the variable speed drive.

7. System according to Claim 6, **characterized in that** the cover is produced in two parts.

8. System according to Claim 7, **characterized in that** the seal-tight architecture comprises a gasket compressed between the flange (30) and an area situated at the periphery of the opening (200) of the frame (2).

9. Method for mounting a variable speed drive, conforming to that defined in Claim 1 or 2, in a frame (2) comprising an opening (200), **characterized in that** it comprises the following steps:
- insertion of the undercut (40) in an edge of the opening (200) to make the top fixing tabs (112) pass through by tilting the variable speed drive (1) relative to the frame (2),
- rotation of the variable speed drive (1) towards the interior of the opening (200) to bring it in the direction of the main axis (X) and make the bottom fixing tabs pass through,
- translation of the variable speed drive (1) in a plane perpendicular to the main axis (X) to disengage the undercut from the edge of the opening,
- translation of the variable speed drive (1) along the main axis (X) so as to drive it in until the flange (30) bears against an area situated at the periphery of the opening (200) produced through the frame (2) and compresses a gasket positioned between the flange (30) and the area situated at the periphery of the opening (200).
